Europäisches Patentamt

European Patent Office

Office européen des brevets

(19)

(11) Publication number: **0 078 676**
**B1**

## EUROPEAN PATENT SPECIFICATION

(12)

(45) Date of publication of patent specification: **14.05.86**

(51) Int. Cl.⁴: **H 03 K 17/96**

(21) Application number: **82305758.3**

(22) Date of filing: **29.10.82**

(54) Touch sensing device.

(30) Priority: **29.10.81 JP 174029/81**
**25.02.82 JP 30235/82**

(43) Date of publication of application:
**11.05.83 Bulletin 83/19**

(45) Publication of the grant of the patent:
**14.05.86 Bulletin 86/20**

(84) Designated Contracting States:
**DE FR GB IT NL**

(56) References cited:
**EP-A-0 015 438**
**US-A-3 862 354**
**US-A-4 068 189**
**US-A-4 266 144**

(73) Proprietor: **FUJITSU LIMITED**
**1015, Kamikodanaka Nakahara-ku**
**Kawasaki-shi Kanagawa 211 (JP)**

(72) Inventor: **Yamaguchi, Hisashi c/o FUJITSU**
**LIMITED**
**Patent Department 1015 Kamikodanaka**
**Nakahara-ku Kawasaki-shi Kanagawa 211 (JP)**
Inventor: **Asano, Toru c/o FUJITSU LIMITED**
**Patent Department 1015 Kamikodanaka**
**Nakahara-ku Kawasaki-shi Kanagawa 211 (JP)**
Inventor: **Takahara, Kazuhiro c/o FUJITSU**
**LIMITED**
**Patent Department 1015 Kamikodanaka**
**Nakahara-ku Kawasaki-shi Kanagawa 211 (JP)**
Inventor: **Kurahashi, Keizo c/o FUJITSU**
**LIMITED**
**Patent Department 1015 Kamikodanaka**
**Nakahara-ku Kawasaki-shi Kanagawa 211 (JP)**
Inventor: **Andoh, Shizuo c/o FUJITSU LIMITED**
**Patent Department 1015 Kamikodanaka**
**Nakahara-ku Kawasaki-shi Kanagawa 211 (JP)**

(74) Representative: **Sunderland, James Harry et al**
**HASELTINE LAKE & CO Hazlitt House 28**
**Southampton Buildings Chancery Lane**
**London WC2A 1AT (GB)**

Courier Press, Leamington Spa, England.

## Description

This invention relates to a touch sensing device.

As a man-machine interface there has been proposed a see-through type touch keyboard for mounting on a display screen of a display unit and for use in inputting to a computer system data corresponding to an area designated by finger touch on the keyboard. For a touch keyboard of this kind, it is important that the touch condition is accurately detected, and various methods have been proposed for achieving this.

In one proposed touch sensing system a change of capacitance between a touch electrode and ground caused by a finger touching the touch electrode is detected. This proposed method is explained, for example, in U.S. Patent No. 3,482,241 and U.S. Patent No. 3,971,013. However this proposed method has disadvantages in that a ratio of touch and non-touch conditions (ON-OFF ratio) is insufficient and misoperation occurs easily.

US—A—3 862 354 discloses a touch sensing device, having a switch with electrodes which can be touched by the human hand, operable to detect touching of the electrodes by the human hand. The device has an oscillator circuit for generating a continuous wave of a particular frequency. In one form of the device, the switch and a parallel-connected inductance constitute a tuning circuit adapted to resonate at the oscillator frequency when the switch electrodes are not touched by the human hand. The output of the oscillator circuit is delivered to this tuning circuit.

Touching of the switch electrodes by the human hand causes a change in voltage level at the connection between the oscillator circuit and the tuning circuit.

Acccording to the present invention there is provided

a touch sensing device having a touch electrode which can be touched by an object, for example a human finger, operable to detect touching of the touch electrode by said object, the device comprising an oscillator, for generating an alternating signal of a constant frequency, a touch sensing circuit, to which the touch electrode is connected, having a parallel resonant circuit tuned to resonate at said constant frequency to which the oscillator is connected, and touching of the touch electrode by said object being detected as a change in the voltage level at the connection between the oscillator and the resonant circuit, characterised in that a circuit element which, together with the equivalent circuit element equivalently provided when the touch electrode is touched by the said object, forms a series resonant circuit, is connected between the touch electrode and the sensing circuit.

An embodiment of the present invention can provide see-through type finger touch sensing device mounted on a display screen for inputting to a computer system data corresponding to an area designated by a finger touch. A touch sensing device is provided which detects a change of capcitance associated with a touch electrode due to a finger touch by using a resonant phenomenon of a resonant circuit.

An embodiment of the present invention can provide a touch sensing device which can accurately and stably detect a touch condition of a touch electrode.

An embodiment of the present invention can provide a highly reliable see-through type touch keyboard which is mounted on a display screen and is capable of generating desired coordinate information corresponding to an area on the display screen in accordance with a designation of such an area by a finger touch.

An embodiment of the present invention can provide a touch sensing system which ensures a large output signal ratio between touch and non-touch conditions (ON-OFF ratio) and thus provides fewer misoperations.

Briefly, an embodiment of the present invention provides a touch sensing device which detects a touch condition of a touch electrode on the basis of the fact that the capacitance associated with the pertinent touch electrode changes in dependence upon the touch and non-touch condition of the touch electrode (that is, in dependence upon whether or not the touch electrode is being touched, for example by a finger), wherein an oscillating circuit which generates an AC signal having a predetermined frequency is connected to the touch electrode via an impedance circuit element, and a resonant circuit tuned to the frequency of the AC signal is connected between the touch electrode and ground. The touch/non-touch condition of the touch electrode is detected as a change of signal voltage value at the connecting point of the impedance circuit and the resonant circuit.

In such an embodiment of the present invention, the resonant circuit connected between the touch electrode and ground is formed as a parallel resonant circuit, and moreover an element which forms a series resonant circuit when considered together with an equivalent circuit element which is effectively added by a touch operation of the touch electrode is also connected between the parallel resonant circuit and the touch electrode. Such a structure contributes to realization of an increased ON-OFF ratio.

Moreover, such a structure enables a high ON-OFF ratio to be maintained even with a relatively high touch electrode resistance. This ability is particularly valuable when a touch electrode is made of a transparent conductive material as, for example, in a see-through type touch keyboard on a display screen.

Reference is made, by way of example, to the accompanying drawings, in which:—

Fig. 1 is a schematic block diagram illustrating an arrangement employing a touch sensing device for assistance in understanding the present invention,

Fig. 2 is a circuit diagram illustrating in more detail an arrangement as shown in Fig. 1,

Figs. 3(A) to 3(D) are waveform diagrams, for assistance in explaining touch condition sensing operations in the arrangement of Fig. 1,

Fig. 4 is a graph showing characteristic curves indicating relationships between frequency and detected output voltages in the arrangement shown in Fig. 2,

Figs. 5(A) and 5(B) are circuit diagrams illustrating respective modified forms of a part of the arrangement shown in Fig. 2,

Fig. 6 is a partly cut away perspective view illustrating in general terms an arrangement in which a touch keyboard, using touch sensing devices, is provided on a display,

Fig. 7 is a perspective view illustrating an electrode arrangement of the touch keyboard of Fig. 6,

Fig. 8 is a schematic circuit diagram illustrating details of a detection signal processing circuit of the keyboard shown in Fig. 6,

Fig. 9 is a circuit diagram illustrating a touch sensing device embodying the present invention,

Fig. 10 is a graph in which characteristic curves illustrate relationships between frequency and detection output voltage in the touch sensing device of Fig. 9,

Fig. 11 is a graph in which characteristic curves illustrate relationships between electrode resistance in a touch keyboard embodying this invention an ON-OFF ratio, with an inset circuit diagram, and

Fig. 12 is a schematic block diagram illustrating a touch input device embodying the present invention.

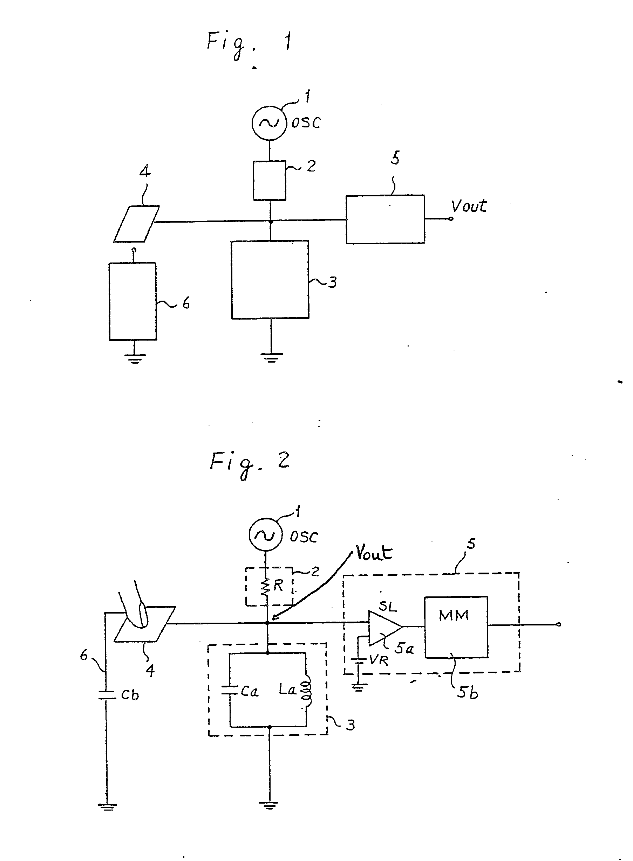

Fig. 1 is a block diagram illustrating in outline an arrangement employing a touch sensing device for assistance in understanding the present invention.

In Fig. 1 an oscillator 1, which sends an alternating signal of a constant frequency, is connected with a resonant circuit 3 via an impedance circuit 2, the other end of the resonant circuit 3 being grounded. The connecting point between the impedance circuit 2 and the resonant circuit 3 is connected to a touch electrode 4 via a lead wire and is also connected to a voltage detection circuit 5.

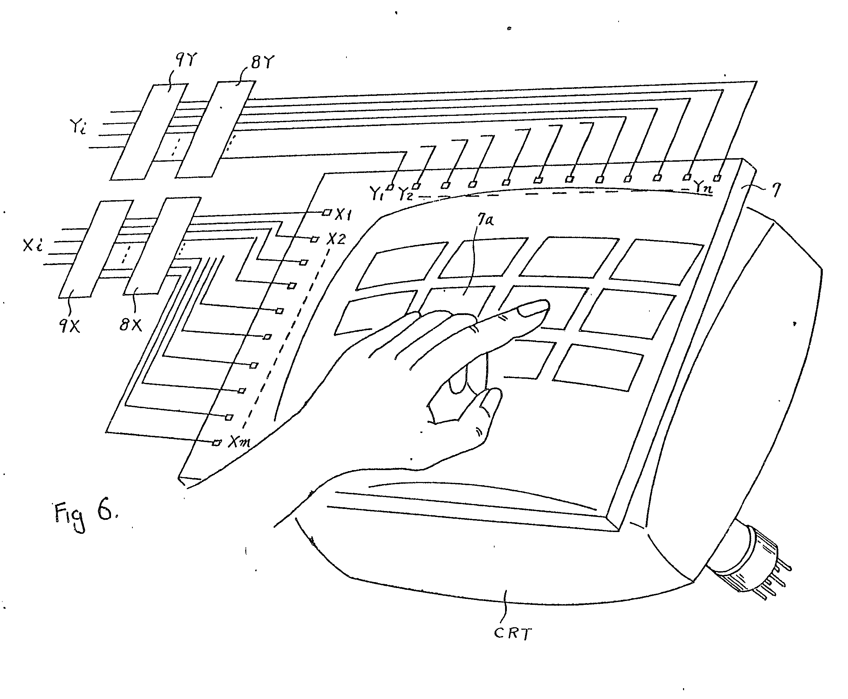

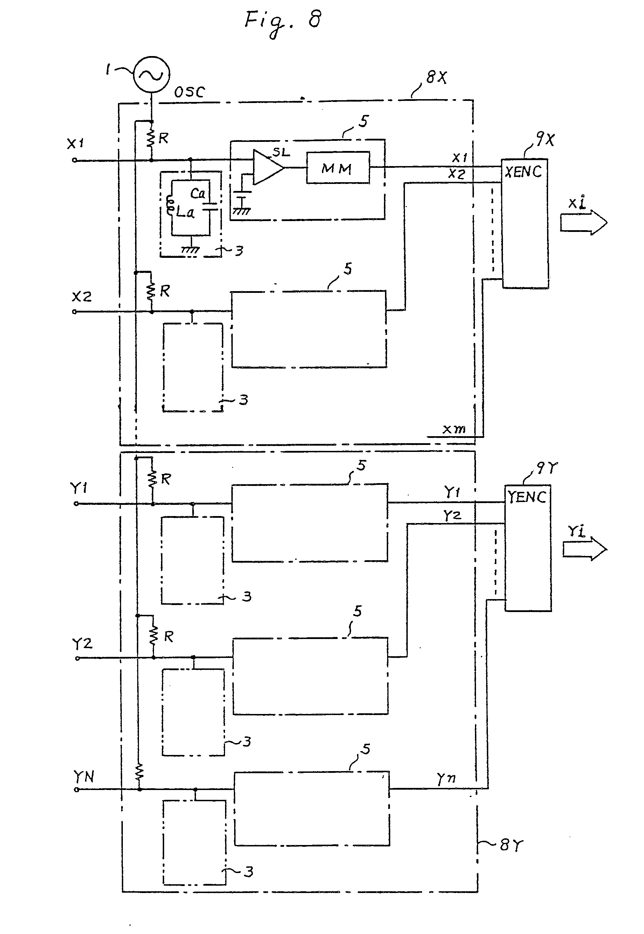

In Fig. 1, 6 is an object to be detected (the touch of which on the touch electrode 4 is to be detected). Generally, the object 6 will be a part of the human body, for example, a finger.

Fig. 2 is a circuit diagram illustrating an example of detailed forms for items indicated by blocks in Fig. 1.

The impedance circuit 2 is, in Figure 2, composed of a resistor R. A different discrete element, or a combination of elements may be used in place of resistor R. The resonant circuit 3 is composed of an LC parallel resonant circuit in which a capacitor Ca and coil La are connected in parallel. The voltage detecting circuit 5 is composed of a slice (threshold) circuit 5a and a monostable circuit 5b. The slice circuit 5a slices an input signal thereto at a constant level and sends an output to the monostable circuit 5b (when the input signal exceeds the slice level). This monostable circuit 5b operates in such a manner that it outputs a signal "1" having a specified width (duration) from an instant at which the level of the input signal thereto changes from "0" to "1" and moreover further outputs a signal "1" having the specified width when the input signal thereto changes again from "0" to "1" whilst an output "1" is being obtained from the monostable. That is, the monostable circuit is a so-called re-start type monostable circuit. A part of the human body which can be placed in contact with the touch electrode 4 can be equivalently represented by a capacitance Cb as shown in Fig. 2.

Here, there will first be considered the case in which a part 6 of the human body is not in contact with the touch electrode 4 shown in Fig. 2. In such a case, an impedance $Z_{off}$ of the LC parallel resonant circuit 3 can be generally expressed by the following equation (1).

$$Z_{off}=Jw_oLa/1(1-w_o^2.La.Ca) \qquad (1)$$

where the inductance of coil La is La(H), and the capacitance of capacitor Ca is Ca(F).

Here, when the relationship between the angular frequency $w_o$ of the oscillator 1 and values of elements La, Ca are selected in accordance with the following equation (2),

$$w_o=1/\sqrt{La.Ca} \qquad (2)$$

the LC parallel resonant circuit 3 enters a resonant condition, the impedance $Z_{off}$ becomes infinite and as a result an output voltage $V_{out}$ (at the connecting point of 2 and 3) becomes almost equal to the output voltage of the oscillator 1.

On the other hand, considering the case in which a part 6 of the human body contacts the touch electrode 4, an impedance $Z_{on}$ of the LC resonant circuit 3 can be expressed by the following equation (3), since the capacitance Cb of a part of the human body is added.

$$Z_{on}=Jw_oLa/(1-w_o^2La(Ca+Cb)) \qquad (3)$$

where Cb is the capacitance of a part of the human body.

Therefore an output voltage $V_{out}$ (at the connecting point of 2 and 3) at this time can be expressed by the following equation:—

$$V_{out}=Z_{on}Vs/(R+Z_{on}) \qquad (4)$$

where R is the resistance value of resistor R and Vs is the output voltage of the oscillator 1.

Thus, the ratio of output voltage $V_{off}$ obtained in the non-touch condition and output voltage $V_{on}$ obtained in the touch condition can be expressed as follows:—

$$V_{off}:V_{on}=1:Z_{on}/(R+Z_{on}) \qquad (5)$$

Consequently, a large ON-OFF ratio can be obtained by properly selecting the values of R, Ca, Cb and La, subject to a requirement for low touch electrode resistance as explained below.

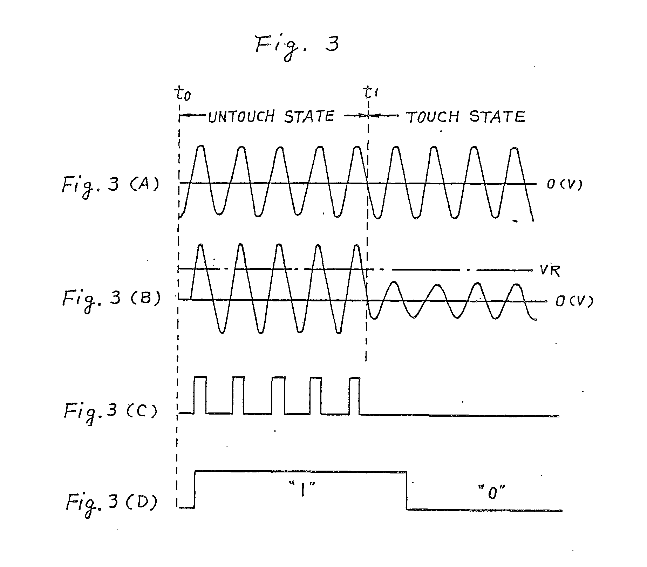

Actually, in Fig. 2, the LC parallel resonant circuit 3 is designed so that it has a resonant frequency same as the frequency, for example 30 kHz, sent from the oscillator 1 and it shows theoretically an infinite impedance in the non-touch condition. Therefore, in a case in which an AC voltage as shown in Fig. 3(A) is output from the oscillator 1, a voltage $V_{off}$ which is almost equal to the oscillation output voltage is applied to the slicer circuit 5a as shown in Fig. 3(B) in the period $t_0$ to $t_1$ in the non-touch condition. As a result, a signal higher than the reference voltage VR is output from the slice circuit 5a as shown in Fig. 3(C) and this is input to the monostable circuit 56. Therefore, an output of the monostable circuit becomes logic "1" as shown in Fig. 3(D) during this period.

When a part of the human body touches the touch electrode 4, at the timing $t_1$ in Figs. 3(A) to 3(D), the resonant circuit 3 changes to a non-resonant condition from the resonant condition because of the addition of the capacitance Cb relating to the human body. Thus, an input to the voltage detecting circuit 5, namely the voltage at the connecting point of the impedance circuit 2 and the resonant circuit 3, becomes smaller than the reference voltage VR, as shown in Fig. 3(B). Therefore, the monostable circuit 5b is not started and its output becomes logic "0" as shown in Fig. 3(D).

The touch and non-touch conditions can thus be sensed as a change of voltage at the connecting point of the impedance circuit 2 and the resonant circuit 3 as a result of the change in the resonating condition of the resonant circuit in dependence upon touch and non-touch of the touch electrode 4 by a part of the human body.

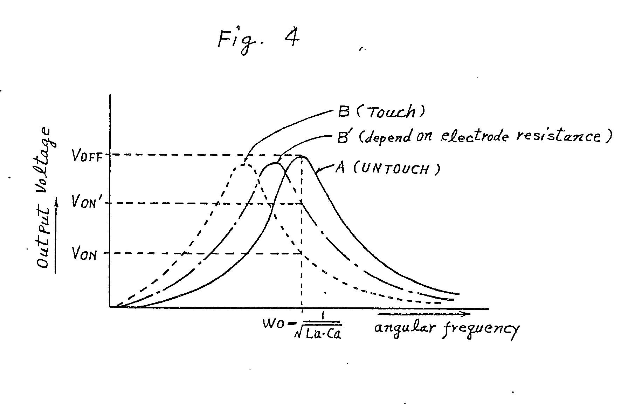

The graph of Fig. 4 illustrates changes in output voltage as a result of changes of capacitance between the touch and non-touch conditions of the touch electrode and consequent changes of resonant characteristics. In the non-touch condition, the resonant point of the parallel resonant circuit 3 matches the angular frequency $w_o$ of the oscillator 1 and thereby a maximum output voltage $V_{OFF}$ can be obtained on a resonant curve A. Meanwhile, when a capacitance Cb, relating to the human body, is added by a finger touch operation to the touch electrode, the resonant point of the parallel resonant circuit deviates to the lower frequency side as illustrated by a curve B for example (for a low touch electrode resistance) and consequently an output voltage of a lower level $V_{ON}$ is obtained for the fixed oscillation frequency of the oscillator 1.

Basically, embodiments of this invention are capable of recognizing the touch condition by detecting the difference between output voltages $V_{OFF}-V_{ON}$ in the finger touch and non-touch conditions as a result of change of resonant point as explained above.

In other contexts an LC parallel circuit might not be used; circuits having other resonant characteristics might be used.

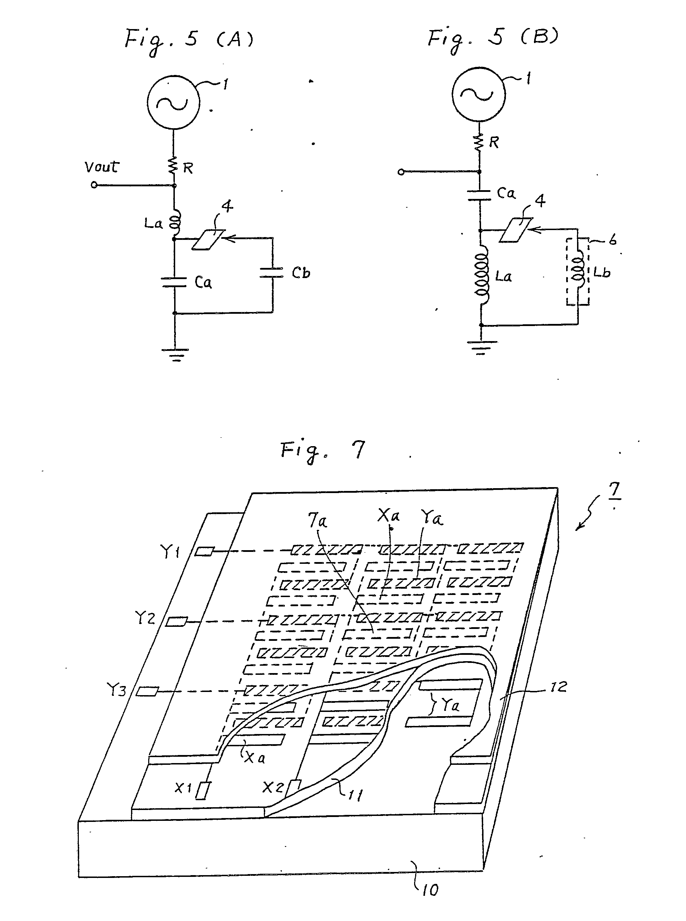

Fig. 5(A) shows an example of a touch sensing device which uses a series resonant circuit, in which a resistor R, a coil La, and a capacitor Ca are connected in series between oscillator 1 and ground, whilst the touch electrode 4 is connected to a point between the coil La and the capacitor Ca. In a case in which the inductance of coil La and the capacitance of capacitor Ca are selected so that resonance is provided at the oscillation frequency of the oscillator 1, the resonant impedance of this series resonant circuit becomes zero.

Therefore, in this case, in the no-finger-touch condition, an output voltage $V_{out}$ ($=V_{oFF}$) becomes ground level, since the LC series resonant circuit is in the resonant condition, but when a capacitance Cb associated with the human body is added by a finger-touch, the resonant condition (at the oscillation frequency of oscillator 1) is lost and an output voltage $V_{out}$ is increased, to the level $V_{ON}$. The touch condition of the touch electrode can be sensed by detecting such output voltage $V_{ON}$.

In the above description it has been assumed that the touch of a part of the human body, providing capacitance Cb, is to be sensed. However, embodiments of this invention can be provided to sense the touch of any object which can change the resonant point of resonant circuit 3.

Namely, the object 6 the touch of which is to be detected can be formed by any means which will manifest some changes in the resonant condition of the resonant circuit in dependence upon the touch/no-touch condition of the touch electrode. As an example, a coil or capacitor, housed in a pen-shaped casing, one end of which is earthed and the other end of which is for contacting the touch electrode, can be used.

This invention has an important application in the realization of a touch input device or touch keyboard or panel having a plurality of sensing points, for providing a man-machine interface.

Fig. 6 is a perspective view of a touch sensing device comprising a see-through type touch keyboard formed on the surface of a CRT display. This keyboard detects the touch of a designated location on the display, corresponding to an item displayed (in that location) on the CRT, and then inputs data relating thereto into a computer. The keyboard comprises a see-through touch panel 7, sensed signal processors 8X, 8Y and encoders 9X, 9Y.

The touch panel 7 has a plurality of X side detecting electrodes X1—Xm arranged in an X direction, a plurality of Y side detecting electrodes Y1—Yn arranged in a Y direction, and a plurality of touch electrode areas 7a defined at the intersections of said X and Y side detecting electrodes.

The sensed signal processors 8X, 8Y provide respectively an oscillator, a resonant circuit and a voltage detecting circuit as explained above and input the voltage levels of X and Y side detecting electrodes to the encoder 9X and 9Y by sensing those voltages in a time sharing manner or in parallel.

The encoders 9X, 9Y output data Xi and Yi designating the location defined by the X electrode and the Y electrode intersecting in the area 7a designated by a finger-touch operation, in the form of binary code signals.

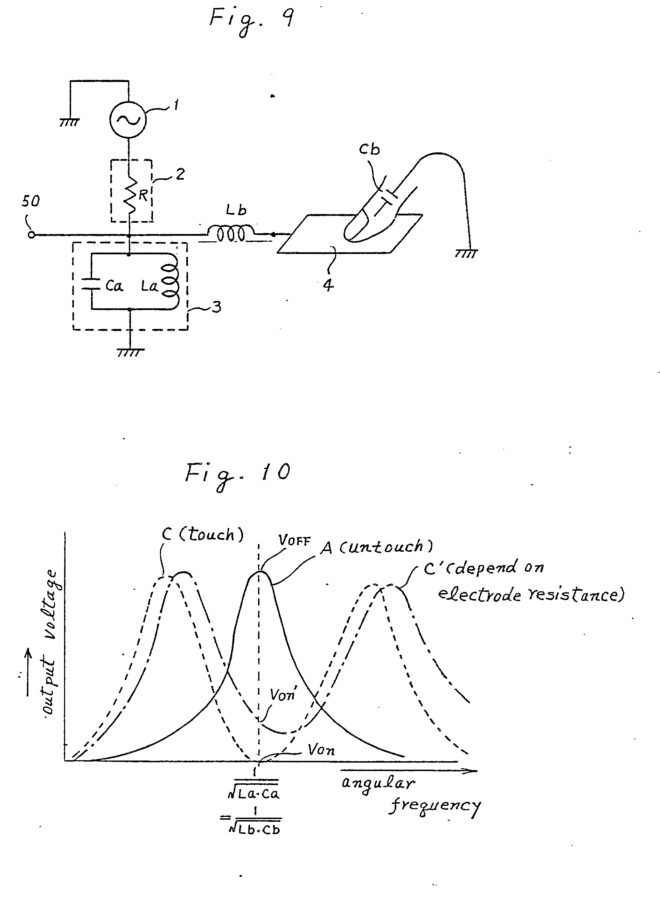

Fig. 7 is a perspective view, partly cut away, showing the electrode layout of the touch panel 7. The panel comprises a transparent glass plate 10 which acts as a base; transparent Y side detecting electrodes Y1—Y3 extending in a transverse direction (left and right in Fig. 7) are provided thereon, and transparent X side detecting electrodes X1—X3 extending in a lengthwise direction (up and down in Fig. 7) are provided on the Y side electrodes, separated from the Y side electrodes by insulating film 11. The upper surface of the panel is covered with a thin insulating film 12.

As is clear from Fig. 7, both X and Y side electrodes provide touch electrode segments Xa, Ya which are arranged at the intersections of the X and Y side electrodes. At each intersection it will be seen that X-touch electrode segments and Y-touch electrode segments are provided in an interdigitated pattern and each touch area 7a, corresponding to an intersection of X and Y side electrodes is defined by such an interdigitated pattern of touch electrode segments. In Fig. 7 both the X and Y side electrodes and the touch electrode segments are formed of transparent conductors. It is, however, possible to form only the touch electrode segment Xa, Ya of transparent conductor and to form the X and Y side bus conductors (X side electrodes, Y side electrodes), connecting these touch segments, of a low resistance metal material such as Cr-Cu-Cr etc, to raise detection sensitivity.

Fig. 8 is a circuit diagram of the detected signal processors 8X, 8Y shown schematically in the block diagram of Fig. 6. In Fig. 8 the processors 8X, 8Y are shown with parallel resonant circuits 3 as in Figure 2.

The circuit of Fig. 8 provides for parallel sensing operation in relation to a plurality of touch areas.

It will be clear from Fig. 8 that resonant circuits 3 and the voltage detecting circuits 5 as explained with reference to Fig. 2 form the sensed signal processors 8X, 8Y. Each resonant circuit 3 is connected to a common oscillating circuit 1 via a respective resistor R which constitutes an impedance circuit element. The connecting point of each resonant circuit and its respective resistor R is connected with a respective sensing electrode. The outputs x1, x2, ..., x m of the voltage detecting circuits 5 associated with respective resonant circuits belonging to an X electrode group are input to encoder 9X, while the outputs y1, y2 ... yn of the voltage detecting circuits 5 associated with respective resonant circuits belonging to a Y electrode group are input to the Y encoder 9Y.

Here, it will be assumed that an operator touches, with a finger, a touch area 7a which is at the intersection of X detecting electrode $X_2$ and the Y detecting electrode $Y_2$. Before an operator touches the touch area, all resonant circuts 3 are in the resonant condition and therefore the levels of the outputs x1, x2, ... xm, y1, y2, ..., yn of all voltage detecting circuits 5 are high, logic "1" and no coordinate data is output from the X side encoder 9X and Y side encoder 9Y.

When an operator touches the touch area 7a, the resonant circuits connected to the X electrode $X_2$ and Y electrode $Y_2$ are placed in the non-resonant condition. As a result, the outputs x2, y2, of the corresponding voltage detecting circuits 5, are set low, logic "O". Therefore "1, 0, 1, 1, ..., 1" is input to the X side encoder 9X whilst "1, 0, 1, 1, 1, ..., 1" is input to the Y side encoder 9Y, and coordinate data with xi=2 in the X direction and yi=2 in the Y direction can be output from the encoders.

With regard to touch sensing devices, or touch input devices or keyboards or panels as explained above, an embodiment of the present invention can provide an improved ON-OFF ratio between the touch and no-touch conditions. Such an embodiment is explained below with reference to Fig. 9.

In Fig. 9, an oscillator 1 is connected, for example, to a resonant circuit 3 via an impedance circuit 2. In the resonant circuit 3 a capacitor Ca and an inductance (coil) La are connected in parallel. The resonant circuit 3 is connected to a touch electrode 4 via an inductance element Lb. Moreover, an output terminal 50 is connected to the connecting point of the impedance circuit 2 and the resonant circuit 3. The embodiment of this invention shown in Fig. 9 is not so different from the touch sensing device shown in Fig. 2 insofar as touch and no-touch conditions in relation to the sensing electrode 4 are detected by a change of voltage at the output terminal 50. However, the touch sensing device of Fig. 9 differs significantly from that shown in Fig. 2 insofar as an inductance element Lb is connected between the resonant circuit 3 and the touch electrode 4.

Fig. 10 is a graph illustrating output voltage vs. frequency characteristics of the touch sensing device using the composite resonance structure shown in Fig. 9, in which graph angular frequency is plotted on the horizontal axis, and the output voltage of output terminal 50 is plotted on the vertical axis. Solid line curve A shows the characteristic in a case in which the finger, for example, does not touch the touch electrode. Broken line curve C shows the characteristic when the finger touches the touch electrode 4.

For this example values are set as follows:—

$$La=Lb \text{ and } Ca=Cb.$$

When the finger does not touch the touch electrode 4, the output voltage vs. frequency characteristic shown by curve A can be obtained and the resonant circuit 3 is in a resonant condition. Therefore, an output voltage at the output terminal 50 becomes a maximum voltage $V_{OFF}$.

When the finger, for example, touches the touch electrode 4, a series circuit comprising the inductance element Lb and body-to-ground capacitance Cb is connected in parallel to the resonant circuit 3. As indicated by curve C in Fig. 10, in the output voltage vs. frequency characteristic, a maximum voltage can be obtained at the two angular frequencies. However, for example when values are set to Cb=Ca, Lb=La so that the frequency of oscillator 1 is tuned to the resonant frequency of the resonant circuit consisting of the series connection of Cb and Lb, the output voltage $V_{ON}$ in the finger-touch condition becomes theoretically zero (V), since the resonant impedance of said series resonant circuit is zero. Accordingly, a difference of output voltages in the touch and no-touch conditions can be made very large and as a result the touch condition of a detecting touch electrode can be sensed very stably. In the touch sensing device of the embodiment in Fig. 2, even if the body-to-ground capacitance Cb is extremely large, for example 1000pF (Cb is actually 50 to 100pF), an output voltage in the touch condition when the frequency of the oscillator is $w_0$ $(=1/\sqrt{La.Ca})$ cannot become zero (V).

For the embodiment of Figure 9 it is assumed that an equivalent circuit element Cb is added when the touch electrode is touched, by a human finger for example. In a case in which an equivalent circuit element Lb is added when the touch electrode is touched the inductance (Lb) provided in Fig. 9 between the touch electrode and output terminal 50 can be replaced by a capacitance (Cb).

In addition, in the touch sensing device of Fig. 9, even when the touch electrode has a resistance of up to 50 kΩ, the touch condition can be detected stably.

When the resistance of the touch electrode 4 in the touch sensing device of Fig. 2 is taken to be r, the output voltage in the touch condition becomes $V_{ON}'$, as shown in the output voltage vs. frequency characteristic curve B' in Fig. 4, and the difference between $V_{ON}'$ and the output voltage $V_{OFF}$ can become very small. However, in the touch sensing device using the composite resonant circuit of Fig. 9, as shown in Fig. 10 by output voltage vs. frequency characteristic curve C', for example, even if the touch electrode has a resistance r, the output voltage $V_{ON}'$ in the touch condition is very small because of the effects of the series resonant condition and therefore the touch condition can be sensed stably.

For this reason the touch sensing device of Fig. 2 has required a low touch electrode resistance of 1 to 3 kΩ but for the composite resonant type touch sensing device of Fig. 9 detecting touch electrode resistance can be up to about 50 kΩ as explained above. It thus becomes possible to form a transparent detecting electrode of a transparent conductive material having a comparatively high resistance such as indium oxide ($In_2O_3$) or indium tin oxide (ITO) etc. For example, the possibility of using such electrode materials can provide significant advantages in a touch sensing panel layed on the front side of the display screen of a CRT display.

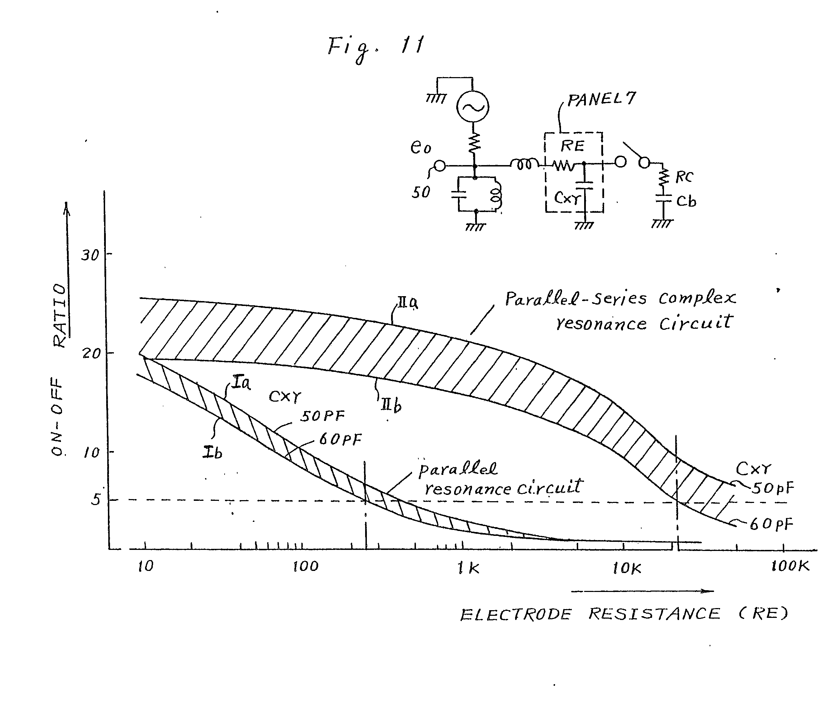

Fig. 11 is a graph in which characteristic curves are given which indicate the results of experimental measurements for investigating the relationships between electrode resistance in a panel or keyboard and the ON-OFF ratio, for the two circuit structures of Fig. 2 and Fig. 9. The ON-OFF ratio is defined as follows with reference to a voltage at output terminal 50:—

ON-OFF ratio$=V_{off}/V_{on}$
(No-touch voltage/touch voltage).

The measuring circuit used is equivalently shown inset at the upper right of Fig. 11 with the circuit structure of Fig. 9 as an example and with a touch panel or keyboard 7 equivalently shown by an electrode resistance RE and an inter-electrode capacitance $C_{XY}$. In the case of this figure, the interelectrode capacitance $C_{XY}$ is a capacitance between one detecting electrode and all the remaining electrodes and is as large as 50 to 60 pF. Moreover, a human body capacitance Cb was estimated as 30 pF whilst the touch resistance $R_C$ was 10 kΩ.

The sensing circuit using only the parallel resonance structure as explained in Fig. 2 shows a trend that the ON-OFF ratio rapidly becomes smaller as the electrode resistance RE becomes larger, as indicated by the region between the curves la and lb in Fig. 11. This makes an accurate sensing operation very difficult when the electrode resistance becomes 1 kΩ or more. Therefore, when using a sensing circuit as shown in Fig. 2, it is desirable to keep the electrode resistance to 200Ω or less in order to obtain a practically useful ON-OFF ratio of 5 or more and it is recommended to provide the buses making up the X and Y electrodes of a low resistance metal conductor as explained above.

On the other hand, in a sensing circuit using a parallel-series composite resonance structure as explained for Fig. 9 the ON-OFF ratio suffers to a lesser degree adverse effects due to increased electrode resistance, as illustrated by the region between the curves lla and llb of Fig. 11, ensuring an ON-OFF ratio of 10 or more in the range of the electrode resistance of 10 kΩ or less. Therefore, even in a case in which the electrodes of a touch panel or keyboard are composed of a transparent conductive material, a stable and reliable sensing operation is assured, since the electrode resistance is about as small as 20 kΩ or less.

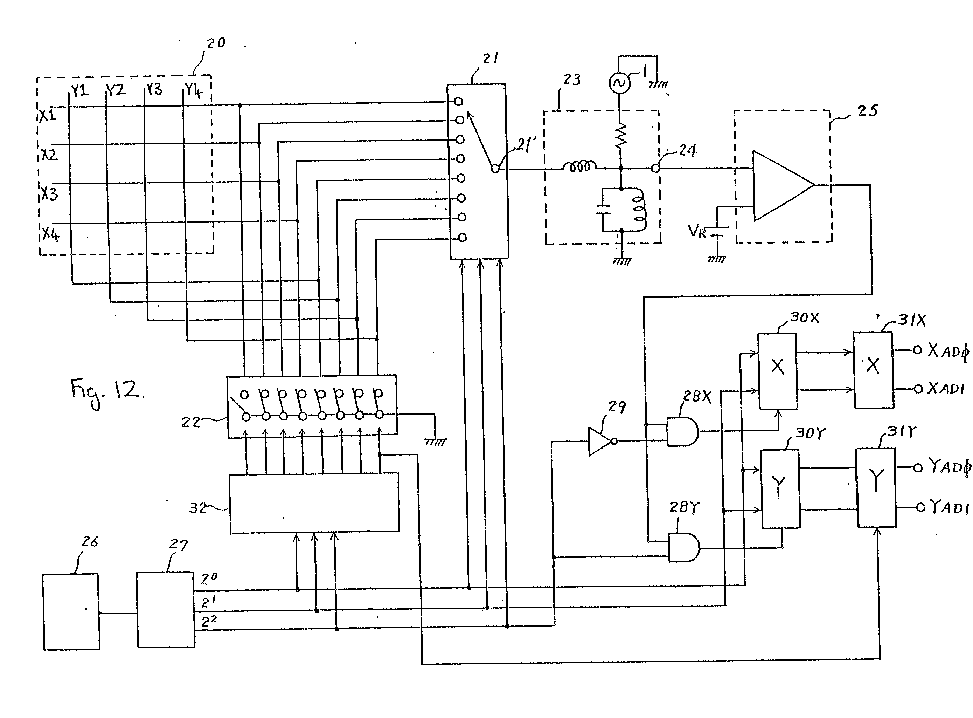

Fig. 12 is a block diagram illustrating a circuit structure of another touch keyboard embodying the present invention, wherein touched electrodes are detected on a time sharing basis.

A touch panel or keyboard 20 has a multiplexer 21 and a plurality of X and Y detecting electrodes Y1 to Y4, X1 to X4 connected to an analog switch array 22. An output terminal 21' of multiplexer 21 is connected with a sensing circuit 23 utilizing the parallel-series composite resonant circuit explained above with reference to Fig. 9 and an output 24 of sensing circuit 23 is connected with a comparator 25 for comparing an output voltage level from sensing circuit 23 with a reference voltage $V_R$. An address signal is generated by a clock signal generator 26 and a 3-bit counter 27 in order to uniquely designate a detecting electrode connected to detecting circuit 23. The multiplexer 21 connects the detecting electrodes one by one, in turn, to the detecting circuit 23 in accordance with the condition of a 3-bit address signal ($2^0$, $2^1$, $2^2$) sent from the counter 27. An output of the comparator 25 is input to a pair of AND gate circuits 28X and 28Y. AND gate circuit 28X outputs touch detection signals relating to X side electrodes. The AND gate circuit 28X receives a signal obtained by inverting the third (highest order) bit of the counter output of counter 27 used as the address signal, by means of the inverter 29, and a sense signal from comparator 25. When the inverted third bit from counter 27 is "1" the AND gate circuit 28X is opened: when the inverted third bit is "1" the sense signal from comparator 25 relates to an X side electrode. The other AND gate circuit 28Y outputs touch detection signals relating to Y side electrodes. The AND gate circuit receives the third bit from counter 27, uninverted, and a sense signal from comparator 25. The outputs of the AND gate circuits 28X, 28Y are first stored in the temporary registers 30X, 38Y, and the address of the X side electrode or Y side electrode (given by the first and second bits from counter 27) is also stored when a touch signal is detected. Contents of these temporary registers are read into output registers 31X and 31Y when the scanning of one cycle is completed for both X and Y side electrodes and then the contents are sent to a computer as a signal indicating a touched electrode position. Meanwhile, the 3-bit address signal (from counter 27) for scanning is decoded by the decoder 32, during electrode scanning by the multiplexer 21, and then applied to the analog switch array 22. This analog switch array operates in such a way as to connect all electrodes, except for the one detecting electrode presently connected to the sensing circuit 23 via the multiplexer 21, to ground potential. Thereby, the effects of inter-electrode capacitance can be mitigated by clamping non-selected electrodes to ground potential.

As will be understood from above description, embodiments of the present invention can provide a large output voltage ratio between touch OFF and touch ON conditions by making use of a resonant circuit and can also provide that stable and reliable touch sensing operation can be accomplished for a see-through type touch input device or touch keyboard.

A touch sensing device embodying this invention may provide a touch panel having a plurality of transparent touch electrodes, an LC parallel resonant circuit connected to the touch electrodes, and an oscillation circuit. The LC resonant circuit has a resonant point at the oscillation frequency of the oscillation circuit. The touch/non-touch condition of a touch electrode is detected as a change of voltage value at the connecting point of the LC resonant circuit and touch electrode. An improved ON-OFF ratio is provided.

In the above description of embodiments of the present invention an impedance element or elements (2) is or are provided separately from the oscillator (1). It may be possible that the oscillator itself can provide an impedance factor, without a separate impedance element.

## Claims

1. A touch sensing device having a touch electrode (4; X1 to Xm, Y1 to Yn; X1, X2, X3, X4, Y1, Y2, Y3, Y4) which can be touched by an object, for example a human finger, operable to detect touching of the touch electrode by said object, the device comprising an oscillator (1, 2), for generating an alternating signal of a constant frequency, a touch sensing circuit (3), to which the touch electrode is connected, having a parallel resonant circuit (3, La, Ca) tuned to resonate at said constant frequency to which the oscillator is connected, and touching of the touch electrode by said object being detected as a change in the voltage level at the connection between the oscillator and the resonant circuit, characterised in that a circuit element (Lb) which, together with the equivalent circuit element (Cb) equivalently provided when the touch electrode is touched by the said object, forms a series resonant circuit, is connected between the touch electrode and the sensing circuit.

2. A touch sensing device as claimed in claim 1, having a plurality of touch electrodes (X1 to Xm, Y1 to Yn; X1, X2, X3, X4, Y1, Y2, Y3, Y4) each of which can be touched by an object (6), for example a human finger, and operable to detect touching of any touch electrode of the plurality by said object, the device comprising a plurality of such touch sensing circuits (3), each having such a parallel resonant circuit (3, La, Ca) to which the oscillator (1, 2) is connected, connected to respective touch electrodes (X1 to Xm, Y1 to Yn; X1, X2, X3, X4, Y1, Y2, Y3, Y4) each via such a circuit element (Lb).

3. A touch sensing device as claimed in claim 1, having a plurality of such touch electrodes (X1, to Xm, Y1 to Yn; X1, X2, X3, X4, Y1, Y2, Y3, Y4) each of which can be touched by an object (6), for example the human finger, and operable to detect touching of any touch electrode of the plurality by said object, the device comprising means (9X, 9Y, 21) for connecting the touch sensing circuit (3) to each of the touch electrodes (X1 to Xm, Y1 to Yn; X1, X2, X3, X4, Y1, Y2, Y3, Y4) in turn, each connection via such a circuit element (Lb).

4. A device as claimed in claim 2 or 3, wherein the touch electrodes (X1 to Xm, Y1 to Yn, X1, X2, X3, X4, Y1, Y2, Y3, Y4) form parts of a see-through type touch panel (7) on a display screen of a display unit (CRT), and are formed on a transparent substrate (10) insulated from one another.

5. A device as claimed in claim 4, wherein the touch electrodes include X electrodes (X1, X2), extending in an X direction, and Y electrodes (Y1, Y2, Y3), extending in a Y direction across the X electrodes and wherein touch segments (Xa, Ya) are provided on the X and Y electrodes at each electrode crossing location.

6. A device as claimed in claim 5, wherein the touch segments (Xa, Ya) are formed of transparent conductor material and the remainder of the touch electrodes (X1, X2, Y1, Y2, Y3) is formed of a low resistance metal conductor material.

7. A device as claimed in claim 5, wherein the touch electrodes (X1, X2, Y1, Y2, Y3), including the touch segments (Xa, Ya), are formed of transparent conductor material.

8. A device as claimed in any preceding claim, wherein the oscillator (1) is connected to the or each resonant circuit (3) via an or a respective impedance circuit (2), and wherein the connection between the oscillator (1) and the or a resonant circuit (3), a change in the voltage level of which connection indicates touching of the or a touch electrode, is the connection point of that resonant circuit (3) and the or the respective impedance circuit (2).

9. A device as claimed in any preceding claim, wherein the or each resonant circuit (3) is an LC parallel resonant circuit comprising a coil (La) and a parallel connected capacitor (Ca).

10. A devica as claimed in any preceding claim, wherein said circuit element is an inductance (Lb) and said equivalent circuit element is a capacitance (Cb), for example human body-to-ground capacitance.

11. A device as claimed in any one of claims 1 to 9, wherein the said circuit element is a capacitance and said equivalent circuit element is an inductance.

**Patentansprüche**

1. Berührungsempfindliche Vorrichtung, mit einer Berührungselektrode (4; X1 bis Xm, Y1 bis Yn; X1, X2, X3, X4, Y1, Y2, Y3, Y4), die durch ein Objekt berührt werden kann, z.B. einen Menschenfinger, und welche die Berührung der Berührungselektrode durch das genannte Objekt feststellen kann, welche Vorrichtung einen Oszillator (1, 2) zur Erzeugung eines Wechselsignals von konstanter Frequenz umfaßt, eine mit der Berührungselektrode verbundene Berührungsfühlschaltung (3), die einen parallelen Resonanzkreis (3, La, Ca) umfaßt, der abgestimmt ist, um mit der genannten konstanten Frequenz zu schwingen, mit welcher der Oszillator verbunden ist, und bei welcher das Berühren der Berührungselektrode durch das genannte Objekt als eine Änderung des Spannungspegels an der Verbindung zwischen dem Oszillator und dem Resonanzkreis gefühlt wird, dadurch gekennzeichnet, daß ein Schaltelement (Lb), welches

zusammen mit dem Äquivalenzkreiselement (Cb) äquivalent vorgesehen ist, wenn die Berührungselektrode durch das genannte Objekt berührt wird, eine Reihenresonanzschaltung bildet, zwischen der Berührungselektrode und der Fühlschaltung angeschlossen ist.

2. Berührungsempfindliche Vorrichtung nach Anspruch 1, mit einer Vielzahl von Berührungselektroden (X1 bis Xm, Y1 bis Yn; X1, X2, X3, X4, Y1, Y2, Y3, Y4), von denen jede durch ein Objekt (6), z.B. einen Menschenfinger, berührt werden kann, und die die Berührung von irgendeiner der genannten Anzahl von Berührungselektroden durch das Objekt feststellen kann, welche Vorrichtung eine Vielzahl von solchen berührungsempfindlichen Schaltungen (3) umfaßt, von denen jede solch einen parallelen Resonanzkreis (3, La, Ca) umfaßt, mit welchem der Oszillator (1, 2) verbunden ist, und der mit entsprechenden Berührungselektroden (X1 bis Xm, Y1 bis Yn; X1, X2, X3, X4, Y1, Y2, Y3, Y4) jeweils über ein solches Schaltungselement (Lb) verbunden ist.

3. Berührungsempfindliche Vorrichtung nach Anspruch 1, mit einer Vielzahl von solchen Berührungselektroden (X1 bis Xm, Y1 bis Yn; X1, X2, X3, X4, Y1, Y2, Y3, Y4), von denen jede durch ein Objekt (6), z.B. einen Menschenfinger, berührt werden kann, und welche die Berührung von irgendeiner der genannten Anzahl von Elektroden durch das genannte Objekt fühlen kann, welche Vorrichtung einrichtungen (9X, 9Y; 21) zur Verbindung der berührungsempfindlichen Schaltungen (3) mit jeder der Berührungselektroden (X1 bis Xm, Y1 bis Yn; X1, X2, X3, X4, Y1, Y2, Y3, Y4) der Reihe nach umfaßt, wobei jede Verbindung über solche ein Schaltungselement (Lb) erfolgt.

4. Vorrichtung nach Anspruch 2 oder 3, bei welcher die Berührungselektroden (X1 bis Xm, Y1 bis Yn, X1, X2, X3, X4, Y1, Y2, Y3, Y4) Teile einer durchsichtigen Berührungstafel (7) auf einem Anzeigeschirm einer Anzeigeeinrichtung (CRT) bilden und, isoliert voneinander, auf einem transparenten Substrat (10) gebildet sind.

5. Vorrichtung nach Anspruch 4, bei welcher die Berührungselektroden X-Elektroden (X1, X2) umfassen, die sich in X-Richtung erstrecken, und Y-Elektroden (Y1, Y2, Y3), die sich in Y-Richtung quer zu den X-Elektroden erstrecken, und bei welcher Berührungssegmente (Xa, Ya) auf den X- und Y-Elektroden an jedem Elektrodenkreuzungsort vorgesehen sind.

6. Vorrichtung nach Anspruch 5, bei welcher die Berührungssegmente (Xa, Ya) auf transparentem Leitermaterial gebildet sind und der Rest der Berührungselektroden (X1, X2, Y1, Y2, Y3) auf einem Metalleitermaterial niedrigen Widerstands gebildet ist.

7. Vorrichtung nach Anspruch 5, bei welcher die Berührungselektroden (X1, X2, Y1, Y2, Y3) die Berührungssegmente (Xa, Ya) umfassen, die aus transparentem Leitermaterial gebildet sind.

8. Vorrichtung nach einem der vorhergehenden Ansprüche, bei welcher der Oszillator (1) mit dem oder jedem Resonanzkreis (3) über einen oder einen jeweiligen Impedanzkreis (2) verbunden ist, und bei welcher die Verbindung zwischen dem Oszillator (1) und dem oder einem Resonanzkreis (3), wobei ein Wechsel des Spannungspegel der Verbindung die Berührung von der oder einer Berührungselektrode anzeigt, der Verbindungspunkt von dem Resonanzkreis (3) und dem oder dem jeweiligen Impedanzkreis (2) ist.

9. Vorrichtung nach einem der vorhergehenden Ansprüche, bei welcher der oder jeder Resonanzkreis (3) ein LC-Parallel-Resonanzkreis ist, der eine Spule (La) und einen parallel angeschlossenen Kondensator (Ca) umfaßt.

10. Vorrichtung nach einem der vorhergehenden Ansprüche, bei welcher das genannte Schaltelement eine Induktanz (Lb) ist und das genannte äquivalente Schaltungselement eine Kapazität (Cb) ist, z.B. eine Menschenkörper-Erde Kapazität.

11. Vorrichtung nach einem der Ansprüche 1 bis 9, bei welcher das genannte Schaltungselement eine Kapazität und das genannte äquivalente Schaltungselement eine Induktanz ist.

## Revendications

1. Dispositif sensible à l'effleurement comportant une électrode d'effleurement (4; X1 à Xm, Y1 à Yn; X1, X2, X3, X4, Y1, Y2, Y3, Y4) qui peut être effleurée par un objet, par exemple un doigt humain, et ayant pour fonction de détecter l'effleurement de l'électrode d'effleurement par l'objet, le dispositif comprenant un oscillateur (1, 2) pour engendrer un signal alternatif d'une fréquence constante, un circuit sensible à l'effleurement (3), auquel l'électrode d'effleurement est connectée, comportant un circuit résonnant parallèle (3, La, Ca) accordé pour résonner à la fréquence constante et auquel est connecté l'oscillateur, et l'effleurement de l'électrode d'effleurement par l'objet étant détecté comme une variation du niveau de tension au point de connexion entre l'oscillateur et le circuit résonnant, caractérisé en ce qu'un élément de circuit (Lb), qui constitue un circuit résonnant série avec l'élément de circuit équivalent (Cb) fourni de façon équivalente quand l'électrode d'effleurement est effleuré par l'objet, est connecté entre l'électrode d'effleurement et le circuit sensible.

2. Dispositif sensible à l'effleurement selon la revendication 1, comportant un ensemble d'électrode d'effleurement (X1 à Xm, Y1 à Yn; X1, X2, X3, X4, Y1, Y2, Y3, Y4) qui peuvent être chacune effleurées par un objet (6), par exemple un doigt humain, et ayant pour fonction de détecter l'effleurement de n'importe quelle électrode d'effleurement de l'ensemble par l'objet, le dispositif comprenant un ensemble de tels circuits sensibles à l'effleurement (3), comportant chacun un tel circuit résonnant parallèle (3, La, Ca) auquel l'oscillateur (1, 2) est connecté, connectés aux électrodes d'effleurement respectives (X1 à Xm, Y1 à Yn; X1, X2, X3, X4, Y1, Y3, Y4) chacun par l'intermédiaire d'un tel élement de circuit (Lb).

3. Dispositif sensible à l'effleurement selon la revendication 1, comportant un ensemble de telles électrodes d'effleurement (X1 à Xm, Y1 à Yn, X1, X2, X3, X4, Y1, Y2, Y3, Y4) pouvant être effleurées chacune par un objet (6) par exemple le doigt humain, et ayant pour fonction de détecter l'effleurement de n'importe quelle électrode d'effleurement de l'ensemble par l'objet, le dispositif comprenant des moyens (9X, 9Y, 21) pour connecter le circuit sensible à l'effleurement (3) à chacune des électrodes d'effleurement (X1 à Xm, Y1 à Yn, X1, X2, X3, X4, Y1, Y2, Y3, Y4) à leur tour, chaque connexion étant réalisée par l'intermédiaire d'un tel élément de circuit (Lb).

4. Dispositif sensible à l'effleurement selon l'une quelconque des revendications 2 et 3, où les électrodes d'effleurement (X1 à Xm, Y1 à Yn; X1, X2, X3, X4, Y1, Y2, Y3, Y4) constituent des parties d'un panneau à effleurement (7) du type pour voir à travers sur un écran de visualisation d'une unité de visualisation (CRT), et sont formées sur un substrat transparent (10) en étant isolées les unes des autres.

5. Dispositif sensible à l'effleurement selon la revendication 4, où les électrodes d'effleurement comprennent des électrodes X (X1, X2), s'étendant dans une direction X, et des électrodes Y (Y1, Y2, Y3) s'étendant dans une direction Y transversalement aux électrodes X, et où des segments d'effleurement (Xa, Ya) sont fournis sur les électrodes X et Y à chaque emplacement de croisement d'électrodes.

6. Dispositif selon la revendication 5, où les segments d'effleurement (Xa, Ya) sont constitués d'un matériau conducteur transparent et où le reste des électrodes d'effleurement (X1, X2, Y1, Y2, Y3) est constitué d'un matériau conducteur métallique de faible résistance.

7. Dispositif selon la revendication 5, où les électrodes d'effleurement (X1, X2, Y1, Y2, Y3) y compris les segments d'effleurement (Xa, Ya) sont constitués d'un matériau conducteur transparent.

8. Dispositif selon l'une quelconque des revendications précédentes, où l'oscillateur (1) est connecté au circuit ou à chaque circuit résonnant (3) par l'intermédiaire d'un circuit ou de l'un respectif de plusieurs circuits d'impédance (2), et où le point de connexion entre l'oscillateur (1) et le circuit ou un circuit résonnant (3), dont le niveau de tension indique, par sa variation, l'effleurement de l'électrode ou d'une électrode d'effleurement est le point de connexion de ce circuit résonnant (3) et du circuit d'impédance (2) ou de celui des circuits d'impédance (2) qui lui est respectivement associé.

9. Dispositif selon l'une quelconque des revendications précédentes, où le circuit ou chaque circuit résonnant (3) est un circuit résonnant parallèle LC comprenant une bobine (La) et un condensateur connecté en parallèle (Ca).

10. Dispositif selon l'une quelconque des revendications précédentes, où l'élément de circuit est une inductance (Lb) et l'élément de circuit équivalent est une capacité (Cb), par exemple la capacité du corps humain à la masse.

11. Dispositif selon l'une quelconque des revendications 1 à 9, où l'élément de circuit est une capacité et l'élément de circuit équivalent est une inductance.

**0 078 676**

Fig. 1

Fig. 2

## Fig. 3

Fig. 4

Fig. 5 (A)

Fig. 5 (B)

Fig. 7

Fig 6.

5

# 0 078 676

Fig. 8

Fig. 9

Fig. 10

7

Fig. 11

PANEL 7

ELECTRODE RESISTANCE (RE)

0 078 676

Fig. 12.

0 078 676